# EUROPEAN PATENT APPLICATION

(11) **EP 4 300 815 A1**
(43) Date of publication of application: **03.01.2024**
(21) Application number: 22382619.9
(22) Date of filing: 30.06.2022
(51) Int. Cl.: H02S 20/26, H02S 20/25, H02S 20/22, H01L 51/42, H01L 51/44, E04F 13/00

(54) **PHOTOVOLTAIC PANEL ON CERAMIC SUPPORT**

(71) Applicant: Sociedad Anónima Minera Catalano-Aragonesa, 50001 Zaragoza (ES)
(72) Inventor: CABALLERO LÓPEZ, MIGUEL ÁNGEL, 50001 ZARAGOZA (ES); BILBAO PARDOS, AINHOA, 50001 ZARAGOZA (ES); LIRA-CANTÚ, MÓNICA, 08193 BARCELONA (ES)
(74) Representative: Schäfer, Matthias W.

(57) **Abstract**

Photovoltaic panel on ceramic substrate, particularly suitable for panels on ventilated facades, which uses a transparent conductive electrode layer on the ceramic substrate, consisting in AZO, where AZO is Aluminium (Al) doped Zinc Oxide (ZnO), on which are arranged, in this sequence, a semi-transparent layer of titanium dioxide TiO₂, a perovskite layer, meaning any natural or synthetic material having the same type of crystalline structure as calcium titanate (CaTiO₃), generally ABO₃, a transparent gap-conducting layer, a transparent conductive electrode layer and at least one transparent protective encapsulant layer.

This invention solves the problem of support roughness, allowing a photovoltaic panel suitable for any ceramic substrate, providing photovoltaic energy generation combined with a structural and/ or decorative function, compatible with the screen printing and printing techniques, processes and machinery commonly used in the ceramic industry.

## Description

This description refers to a photovoltaic panel on a ceramic substrate, particularly suitable for panels on ventilated facades, which uses a transparent conductive electrode layer on the ceramic substrate, consisting in AZO, where AZO is Aluminium (Al) doped Zinc Oxide (ZnO), on which are arranged, in this sequence, a semi-transparent layer of titanium dioxide TiO₂, a layer with a crystalline perovskite structure, a transparent gap-conducting layer, a transparent layer of conductive electrode and at least one last transparent protective encapsulant coat.

### Field of invention

This invention relates to the manufacturing of photovoltaic panels on ceramic substrates.

### Current state of the art

At the present moment, various types of photovoltaic panels are known and used to produce electrical energy out of light. Among them we can highlight the following as the most common:
- Monocrystalline silicon solar panels (M-Si). These consist of a single silicon crystal with a very uniform structure. They guarantee a higher performance than other technologies because silicon atoms are perfectly aligned, enabling conductivity. These cells consist of thin slices of a single crystal, which gives them the highest efficiency but, due to the manufacturing process, they are the most expensive and heaviest. The efficiency of monocrystalline panels on average is 15-20 %.
- Polycrystalline silicon solar panels (P-Si). These consist of many silicon crystals. They are not so expensive, but have a significantly lower performance. Polycrystalline cells are made by pouring liquid silicon into moulds and then cutting the solidified moulds into wafers. This process makes polycrystalline cells less expensive, but also less efficient than monocrystalline cells. The efficiency of monocrystalline panels on average is 13-16 %.

These two more conventional types of solar panels have a high weight and thickness in relation to the energy produced, and therefore require metallic support structures. They can only be placed on buildings by using metallic substrates or concrete structures, and are normally placed on non-visible parts, such as roofs, due to the high and unpleasant visual impact they produce, which makes them difficult to integrate into any decoration or architectural project.
- Thin-film solar panels. This third type is obtained by applying several layers of photovoltaic material on a base. Compared to crystalline, it is easier to manufacture, but has a significantly lower efficiency. Thin-film solar panels are manufactured using an extra-thin layer of semiconductor material, so they can be significantly thinner. These panels are much less expensive than silicon-based panels, although they are also much less efficient at converting sunlight into electricity. Thin-film cells are mainly used in low-voltage applications.

They can also be used to create flexible building materials. When a solar panel is integrated into a structure, it is known as building-integrated photovoltaics. Normally these integrated solar panels are mounted on metallic plates or glass, but they have the disadvantage that they absolutely need an even support, such as metal, glass or some kind of plastic, in order to apply the semiconductor material, which means that they are not applicable momentarily on rough surfaces such as ceramic, making it impossible to use ceramic substrates with this type of panels. On the other hand, due to the low voltage they provide and the low efficiency, this type of panel is not very popular.

The use of titanium oxide is already known for this type of thin-film panels, as reflected in the patents ES2350222 *"Óxido de titanio TiO₂ nanocristalino dopado con nitrógeno para aplicaciones fotovoltaicas"* ("Nitrogen-doped nanocrystalline *TiO₂* titanium oxide for photovoltaic applications") and ES2364770 *"Óxido de titanio dopado con niobio para la elaboración de células solares híbridas estables en atmósfera inerte"* ("Niobium-doped titanium oxide for the production of hybrid solar cells stable in an inert atmosphere"), but this does not facilitate their use on ceramic substrates either, although it improves performance slightly.

In order to solve the problem of the low efficiency of thin-film solar panels, it is being working now on the use of perovskite layers in these panels. Although perovskites take their name from the homonymous mineral, perovskite, in this description we will call "perovskite" or "perovskites" any material, whether natural or synthetic, that has the same type of crystal structure as calcium titanate (CaTiO₃), known as the perovskite structure, and which is adopted by many oxides with the chemical formulation ABO₃. Perovskites, especially synthetic perovskites, are potential candidates for their use as non expensive, high-efficiency materials for the commercial photovoltaic industry, as they feature conversion efficiencies of up to 15 % and can be manufactured using the same thin-film manufacturing methods as those used for conventional silicon solar cells. Of particular interest are methylammonium tin halides and methylammonium lead halides for use in dye-sensitised solar cells. Methylammonium lead halides (MALH) are solid compounds with a perovskite structure and a chemical formulation CH₃NH₃ PbX₃, where X = I, Br or CI.

In the cubic crystal structure of CH₃NH₃ PbX₃, the methylammonium cation (CH₃NH₃+) is surrounded by PbX₆ octahedra. The X ions are not fixed and can migrate through the crystal with an activation energy of 0.6 eV; the migration is vacancy-assisted. The methylammonium cations can rotate inside their cages. At ambient temperature, the ions have their CN axis aligned to the directions of the unit cell faces, and the molecules randomly switch to another of the six face directions on a time scale of 3 ps.

The operation of these perovskite-based solar cells is similar to those that comprise traditional panels: a semiconductor absorbs solar energy and initiates an electrons flow, which is captured by the wiring and converted into usable electricity. The main difference between the silicon wafers of traditional panels and perovskites lies in their structure. These last ones have a unique crystallographic structure that makes them highly effective for the conversion of photons of sunlight into usable electricity, with several benefits, most notably higher efficiency and lower cost.

Thus, various techniques are known for the creation or application of perovskite films, as for example described in WO201602745 *"System and method based on low-pressure chemical vapor for fabricating of perovskite film"* and in WO2017043084A1 *"Formation of lead-free perowskite film",* and various technologies are also known for their application in solar panels, as described for example in US20200203083 *"Fabrication of stable perovskite-based optoelectronic devices",* CN113725368A *"NH₄NO₃ interface modified perovskite solar cell",* and 'WO202125049 *"Rapid hybrid chemical vapor deposition for perovskite solar modules",* which have shown the excellent efficiency of this material used in solar panels, but it still has the same problem of needing a smooth support, such as metal, glass or plastic materials, to apply the perovskite and the rest of the materials that make up the photovoltaic panel, which means that they are still not directly applicable on rough surfaces such as ceramics. It is possible to create the photovoltaic panel separately, on an even substrate, and then fix it by means of adhesives to the ceramic, but this gives, in addition to a poor aesthetic finish, many problems due to the deterioration of the adhesives in outdoor use, causing failures and detachments, with the result that for many applications, such as ventilated facades, practical use on ceramic material is not possible.

On the other hand, there are also known procedures such as the one described in ES2208103 *"Protector antimanchas para baldosas cerámicas pulidas de gres y otros sustratos arquitectónicos similares. Composition, procedimiento de aplicación y polimerización (curado) mediante radiación ultravioleta"* ("Protection against stain for polished stoneware ceramic tiles and other similar architectural substrates. Composition, application procedure and polymerisation (curing) by means of ultraviolet radiation") which describe aqueous coating compositions for dirt-resistant surface pore sealing, and thus for the protection of ceramic substrates, but do not contemplate any application on solar cells, nor in applications on perovskite.

We found that there are currently no known processes or structures that allow the manufacturing of perovskite-based photovoltaic panels directly on the rough surface of ceramic building elements.

### Description of the invention

In order to solve the current problems in the manufacture of photovoltaic panels on ceramic supports or substrates, the photovoltaic panel on ceramic substrate of the present invention has been designed, which comprises
- a ceramic substrate,
- a first conductive electrode layer, arranged on the mentioned ceramic substrate, manufactures with AZO, being AZO zinc oxide ZnO doped with aluminium Al,
- a second layer of titanium dioxide TiO₂, arranged on the first conductive electrode layer,
- a third perovskite layer, arranged on the second titanium dioxide *TiO₂* layer,
- a fourth transparent gap conductive layer disposed on the third perovskite layer,
- a fifth transparent conductive electrode layer, arranged on the fourth gap conductive layer, which may alternatively also be made of AZO, like the first conductive electrode layer, and
- a sixth transparent encapsulant layer arranged on the fifth conductive electrode layer.

It is also intended to comprise at least two electrical terminals, preferably arranged each on opposite sides of the photovoltaic panel, and electrically connected to the first AZO conductive electrode layer and to the fifth transparent conductive electrode layer.

The different layers are applied using any of the screen printing and printing techniques, processes and machinery commonly used in the ceramics industry.

The intended use of this photovoltaic panel is on any ceramic substrate, such as tiles, bricks, roof tiles, decorative panels, elements for ventilated facades, etc., although the ceramic substrate will preferably be a module for ventilated facades.

### Benefits of the invention

This photovoltaic panel on a ceramic substrate offers many benefits over those currently available, the most important among them is that thanks to the use of an AZO electrode applied directly on the ceramic material, solving the technical problem of its roughness, it allows a photovoltaic panel suitable for construction on any ceramic substrate, such as tiles, bricks, roof tiles, decorative panels, elements for ventilated facades, etc...

As a consequence of this, the added benefit is that photovoltaic panels can be incorporated into any application in which ceramic elements are or can be normally used: floors, terraces, façade coverings, ventilated facades, etc., allowing photovoltaic energy to be generated on most of the exterior of a building in combination with its structural and/ or decorative function.

Another important benefit is that the layer structure and the materials of which they are composed are compatible with the screen printing and printing methods, processes and machinery commonly used in the ceramics industry, greatly reducing the cost of the necessary investments and the time required for its implementation in ceramic elements.

Another added benefit of this invention is that, thanks to the use of perovskite, there is a significant reduction of the weight of the photovoltaic panel, especially compared to the monocrystalline silicon solar cells normally used, which is extremely important when the ceramic substrate consists of ceramic panels for ventilated facades, or roof tiles. In fact, in experimental tests it has been estimated that these panels, excluding the ceramic substrate, can weigh up to 226 times less than conventional ones generating the same electrical energy.

It is also important to note that this photovoltaic panel, in addition to adding to the ceramic substrates their obvious function of producing electricity, also allows the creation of various aesthetic designs, achieving flexibility in decorating the ceramic substrate by combining or using perovskite of different shapes and colours, making it possible to create special designs, semi-transparent and different colours, geometric motifs or decorative shapes, combining the function of electricity generation with the decorative function.

It is also remarkable that, by using perovskite, it is possible to use diffuse light for the generation of photovoltaic energy, for example indoors, on building facades, etc., while other technologies always require direct light, forcing them to be installed outdoors, for example on roofs, so as not to be penalised by low performance.

It should be also remarked that the structure and manufacturing method of the layers that compound the photovoltaic panel, applied directly on the ceramic, allow the photovoltaic panel to adapt its shape to the surface of the ceramic substrate, enabling it to be used both on flat surfaces and on irregular or geometric or artistic shapes, or any combination of these.

### Description of the drawings

In order to better understand the object of this invention, the annexed drawing shows a practical preferred realisation of a photovoltaic panel on a ceramic substrate.

In this drawing, the figure -1- shows a detail of a sectioned view, showing the layers that compound it.

The figure -2- shows a detail of a sectioned view of one ending of the panel, showing the layers that constitute it and detailing the electrical contacts.

The figure -3- shows a detail of a sectioned view of one ending of the panel, showing the layers that constitute it and detailing the electrical contacts, in a preferred realisation to facilitate the electrical connection in series.

The figure -4- shows an example of a series electrical connection of the plates to each other, with an enlarged detail of the junction of the contacts of one plate to the next.

The figure -5- shows an example of series and parallel electrical connection of the plates to each other.

The figure -6- shows a simplified view of the general crystal structure of perovskite.

### Preferred realisation of the invention

The constitution and characteristics of the invention can be better understood with the following description with reference to the attached drawings.

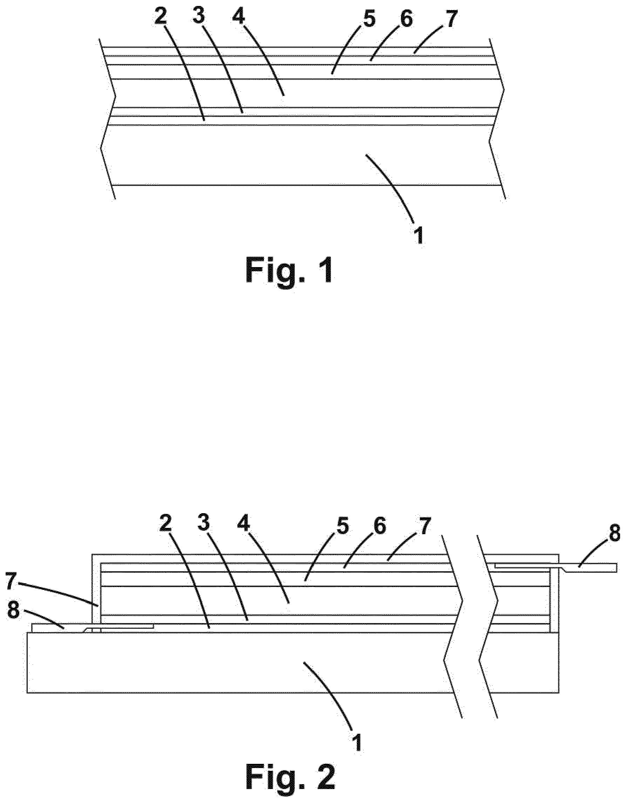

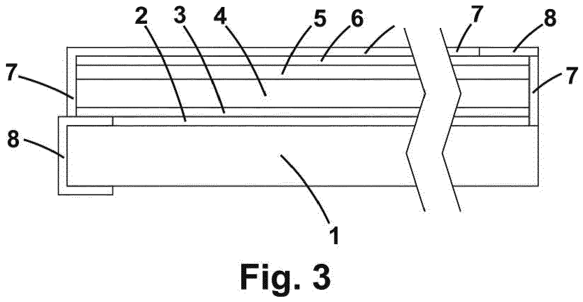

As can be seen in figures 1, 2 and 3, it is illustrated how the photovoltaic panel on ceramic substrate comprises
- a ceramic substrate (1),
- a first conductive electrode layer (2), arranged on the mentioned ceramic substrate (1), manufactures with AZO, being AZO zinc oxide ZnO doped with aluminium Al,
- a second layer of titanium dioxide TiO₂(3), arranged on the first conductive electrode layer (2),
- a third perovskite layer (4), arranged on the second titanium dioxide *TiO₂* layer (3),
- a fourth transparent gap conductive layer (5) disposed on the third perovskite layer (4),
- a fifth transparent conductive electrode layer (6) disposed over the fourth gap conductive layer (5) and
- a sixth transparent encapsulant layer (7) arranged on the fifth conductive electrode layer (6).

Optionally, it is intended that one or more additional layers may be applied on top of the sixth encapsulant layer (7) to reinforce and give more volume to this layer.

The perovskite layer (4) is preferably expected to be between 250 and 800 nm thickness, and most preferably approximately 500 nm thickness.

Furthermore, the electrode layers, and also the other ones, are preferably expected to have a thickness between 20 and 100 nm.

It is also intended to comprise at least two electrical terminals (8), preferably arranged each on opposite sides of the photovoltaic panel, and electrically connected to the first AZO conductive electrode layer (2) and to the fifth transparent conductive electrode layer (6). These electrical terminals (8) can be made by printing, deposition, screen printing or any other method known in the state of the art.

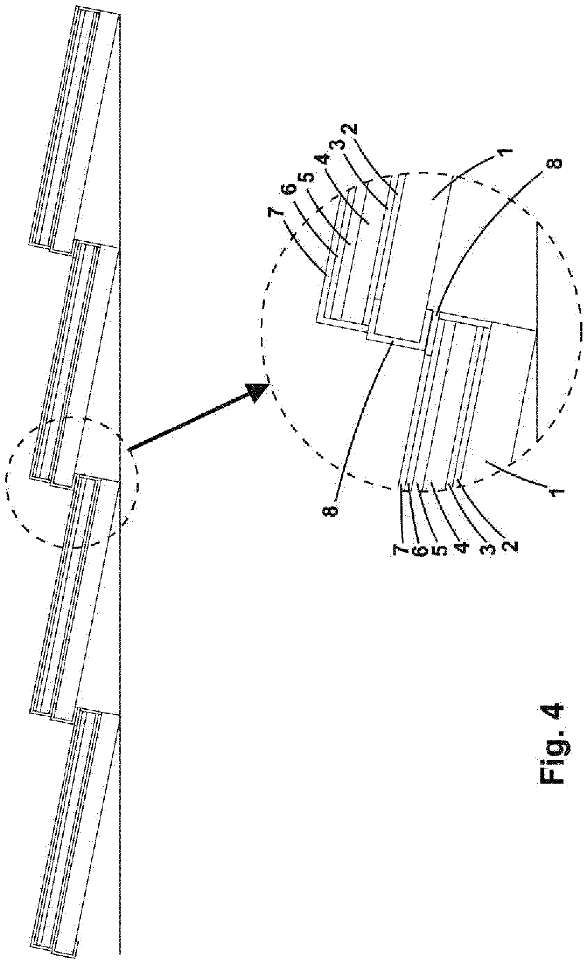

In a preferred realisation, as shown in figure 4, the electrical terminals (8) are arranged in such a way that, when stacked one on top of the other, the electrical terminals (8) of two consecutive plates are mounted one on top of the other, making the electrical contact in series by pressure of these plates.

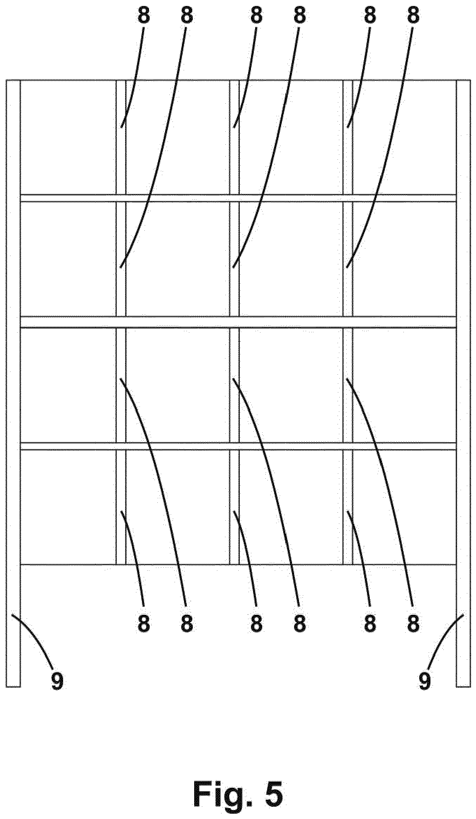

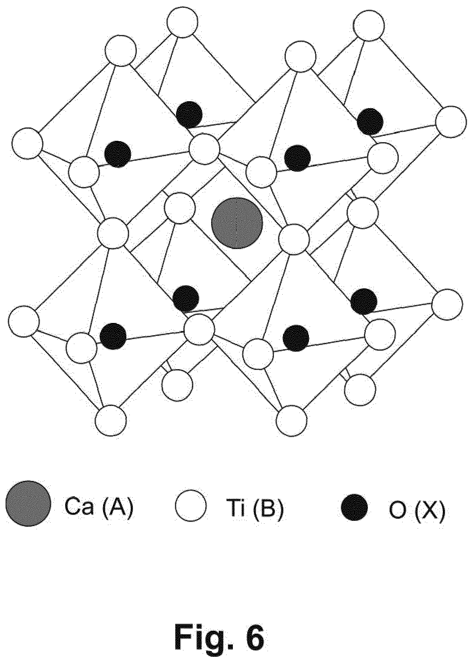

It is also possible to make a parallel connection between several plates, or to combine series and parallel, as illustrated in figure 5, using in cases of parallel connection auxiliary metallic rail bars (9) for interconnection between the electrical terminals (8) of the various plates or serial connections of plates.

The encapsulant layer (7) is made of a low temperature or UV-curable material, which does not require the use of an oven for curing. This encapsulant layer material (7) may be, for example:
- an UV* polymerised acrylic polymer from acrylic monomers and may additionally contain:
   Acrylic ester copolymer,
   natural or synthetic wax,
   pyrogenic silicic acid,
   xyloxanes,
   other rheological additives.
- polyurethane cured in a humid atmosphere,
- epoxy resin.

The epoxy resin could be used either separately conforming the encapsulant layer (7) or as an additional layer on top of the encapsulant layer (7) to reinforce and give more volume to the encapsulant layer if it is made of UV polymerised acrylic polymer or polyurethane cured in a humid atmosphere.

It is intended that the materials used for the gap conductive layer (5), the conductive electrode layer (6), not specified in this description, may be any of the materials commonly known in the state of the art for that application.

In an alternative realisation, the fifth conductive electrode layer (6) is fabricated with AZO, as is the first conductive electrode layer (2).

At the ends of the photovoltaic panel, the transparent encapsulant layer (7) covers the lateral endings of the rest of the layers, in order to protect them from the weather, especially from dust, smoke and humidity.

The application of the different layers is preferably carried out using any of the techniques, processes and machinery commonly used in the ceramics industry, among which we can especially remark: screen printing, rotogravure, flexography, digital ink jet printing and airbrushing.

The techniques of screen printing, rotogravure, flexography and digital ink jet printing make it possible to produce graphic or aesthetic designs, applying them to specific areas. Airbrushing is applied over the entire surface, fullfield, making it particularly suitable for layers that do not require design, such as the final protective coating.

The intended use for this photovoltaic panel is on any ceramic substrate, such as tiles, bricks, roof tiles, decorative panels, elements for ventilated façades, etc., although the ceramic substrate (1) will preferably be a module for ventilated façades. This photovoltaic panel is the result of the experimental tests carried out, in which, in order to allow the creation of this photovoltaic plate on a ceramic substrate with surface roughness, a first layer of AZO oxide has been used, which is a conductive and transparent oxide, suitable for functioning as an electrode.

In order to test the compatibility of the ceramic support (1) with the AZO conductive electrode (ZnO doped with Al), the following experimental tests were carried out:
- Firstly, an AZO ink was prepared by mixing a Zn compound with an Al compound in a solvent consisting of HCI and H₂O, gently adding an additive, heating and leaving the solution to settle. Several tests were carried out, with settle times of 24, 36 and 48 hours.
- The AZO solution was then deposited on the surface of a square ceramic substrate (1) with a surface area of 1 x 1 cm² by means of a deposition process known as "spin coating", that consists of two steps:
   a - Deposition: a small amount of AZO solution was applied onto the centre of the ceramic substrate (1), and after that was being rotated at about 3000 rpm by means of an appropriate rotating support, so that the applied material was spread evenly over the surface, and
   b - Drying: the ceramic substrate (1), with the first AZO conductive electrode layer (2) on it, during 10 to 12 minutes.
   These two steps were repeated several times to achieve an optimum thickness of the first conductive electrode layer (2).

In the experimental tests, the deposition process known as spin coating was used for the deposition of the AZO solution on the surface of the ceramic substrate (1) only because the equipment for spin coating is commonly available in laboratories, but is not limiting, and is substitutable and compatible with any of the deposition techniques that can be used industrially in production plants, such as those mentioned above.

The AZO layer achieved was checked for sufficient electrical conductivity by performing a double-ended measurement using a multimeter in its ohmmeter function.

The second layer of titanium dioxide *TiO₂* (3) on the first AZO conductive electrode layer (2) was prepared using the same deposition process as above.

Scanning electron microscopy analyses (SEM) were carried out before and after the previous layers (both top and side views), checking and verifying the adhesion and resistance of the coatings to the ceramic substrate (1). The crystalline phase was also analysed by X-Ray, finding the peaks corresponding to the *TiO₂* and Al-ZnO that demonstrate the presence and correct formation of both materials on the ceramic.

The final photovoltaic product deposited on the ceramic requires a sealing or encapsulation to protect it from the environment. For the realisation of this final coating or transparent encapsulant layer (7), a low-temperature coating was deposited using the spray technique.

This test was carried out both on the ceramic substrate + AZO conductive electrode layer (2) + *TiO₂* titanium dioxide layer (3) and on some complete solar cells, with the rest of the layers applied on top of the mentioned combination. The compatibility of the materials was tested and their stability was analysed during several hours under a solar simulator (continuous illumination) at temperatures < 80 °C. SEM analysis was performed before and after that.

The expert person in the technology will easily understand that is possible to combine features of different realisations with features of other possible ones, provided that such a combination is technically possible.

All information referring to examples or realisations is part of the description of the invention.

## Claims

1. - Photovoltaic panel on a ceramic substrate (1) **characterised in that** comprises
- a ceramic substrate (1),
- a first conductive electrode layer (2), arranged on the mentioned ceramic substrate (1), manufactures with AZO, being AZO zinc oxide ZnO doped with aluminium Al,
- a second layer of titanium dioxide TiO₂(3), arranged on the first conductive electrode layer (2),
- a third perovskite layer (4), arranged on the second titanium dioxide *TiO₂* layer (3),
- a fourth transparent gap conductive layer (5) disposed on the third perovskite layer (4),
- a fifth transparent conductive electrode layer (6) disposed over the fourth gap conductive layer (5) and
- a sixth transparent encapsulant layer (7) arranged on the fifth conductive electrode layer (6).

2. - Photovoltaic panel on ceramic substrate (1), according to the previous claim, **characterised in that** it comprises at least two electrical terminals (8), electrically connected to the first AZO conductive electrode layer (2) and to the fifth transparent conductive electrode layer (6).

3. - Photovoltaic panel on ceramic substrate, according to claim 2, **characterised in that** the electrical terminals (8) are arranged on one of the sides of the photovoltaic panel.

4. - Photovoltaic panel on ceramic substrate (1), according to any of the previous claims, **characterised in that** the fifth conductive electrode layer (6) is produced with AZO, as is the first conductive electrode layer (2).

5. - Photovoltaic panel on ceramic substrate (1), according to any of the previous claims, **characterised in that** at the endings of the photovoltaic panel, the transparent encapsulant layer (7) covers the lateral endings of the other layers.

6. - Photovoltaic panel on ceramic substrate (1), according to any of the previous claims, **characterised in that** the encapsulant layer (7) is composed of a material chosen from the group formed by an UV polymerised acrylic polymer, based on acrylic monomers, polyurethane cured in a humid atmosphere, and epoxy resin.

7. - Photovoltaic panel on ceramic substrate (1), according to any of claims 1 to 5, **characterised in that** the encapsulant layer (7) comprises an UV-polymerised acrylic polymer based on acrylic monomers which also contains one or more compounds chosen from the group consisting of acrylic ester copolymer, natural or synthetic wax, pyrogenic silicic acid, xyloxanes and rheological additives.

8. - Photovoltaic panel on ceramic substrate (1), according to any of the previous claims, **characterised in that it** comprises one or more additional reinforcement layers arranged on the encapsulant layer (7).

9. - Photovoltaic panel on ceramic substrate (1), according to claim 8, **characterised in that** the additional reinforcement layer or layers arranged on the encapsulant layer (7) are composed of epoxy resin.

10. - Photovoltaic panel on ceramic substrate (1), according to any of the previous claims, **characterised in that** the ceramic substrate (1) is a module for ventilated façade.
